# FASCICULE DE BREVET EUROPEEN

(11) **EP 3 776 641 B1**
(45) Date de publication et mention de la délivrance du brevet: **15.05.2024**
(21) Numéro de dépôt: 19718438.5
(22) Date de dépôt: 21.03.2019
(51) Int. Cl.: H10N 30/073, H03H 3/02, H01L 21/762

(54) **PROCEDE DE TRANSFERT D'UNE COUCHE PIEZOELECTRIQUE SUR UN SUBSTRAT SUPPORT**
VERFAHREN ZUM TRANSFER EINER PIEZOELEKTRISCHEN SCHICHT AUF EIN TRÄGERSUBSTRAT
METHOD FOR TRANSFERRING A PIEZOELECTRIC LAYER ONTO A SUPPORTING SUBSTRATE

(30) Priorité: 26.03.2018 FR 1852573
(43) Date de publication de la demande: 17.02.2021
(73) Titulaire: SOITEC, 38190 Bernin (FR)
(72) Inventeur: BELHACHEMI, Djamel, 38400 Saint Martin D'Heres (FR); BARGE, Thierry, 38160 Chevrieres (FR)
(74) Mandataire: Regimbeau
(86) Numéro de dépôt international: PCT/FR2019/050645
(87) Numéro de publication internationale: WO 2019/186032

(56) Documents cités:
- EP-A1- 0 924 769
- WO-A1-2017/052646
- US-A1- 2003 082 889

## Description

### DOMAINE DE L'INVENTION

La présente invention concerne un procédé de fabrication d'un substrat donneur pour le transfert d'une couché piézoélectrique, ainsi qu'un procédé de transfert d'une telle couche piézoélectrique. L'invention trouve notamment application dans la fabrication de dispositifs radiofréquence, tels que des résonateurs ou des filtres.

### ARRIERE PLAN DE L'INVENTION

Il est connu de fabriquer un dispositif radiofréquence (RF), tel qu'un résonateur ou filtre, sur un substrat comprenant successivement, de sa base vers sa surface, un substrat support, généralement en un matériau semi-conducteur tel que du silicium, une couche électriquement isolante et une couche piézoélectrique.

Les dispositifs à ondes acoustiques de volume (BAW, acronyme du terme anglo-saxon « Bulk Acoustic Wave ») comprennent typiquement une couche piézoélectrique mince (c'est-à-dire d'épaisseur généralement sensiblement inférieure à 1 µm) et deux électrodes agencées sur chaque face principale de ladite couche mince. Un signal électrique, typiquement une variation de tension électrique, appliqué à une électrode est converti en onde élastique qui se propage au travers de la couche piézoélectrique. La propagation de cette onde élastique est favorisée si la fréquence de l'onde correspond à la bande de fréquence du filtre. Cette onde est à nouveau convertie en signal électrique en parvenant à l'électrode située sur la face opposée.

La couche piézoélectrique est typiquement obtenue par transfert d'un substrat épais d'un matériau piézoélectrique (par exemple obtenu par découpe d'un lingot) sur un substrat support. Le substrat support est par exemple un substrat de silicium.

Le transfert de la couche piézoélectrique implique un collage du substrat piézoélectrique épais sur le substrat support, suivi d'un amincissement du substrat piézoélectrique épais, de sorte à ne laisser sur le substrat support qu'une couche piézoélectrique mince, de l'épaisseur souhaitée pour la fabrication du dispositif RF.

Pour une bonne adhésion du substrat piézoélectrique sur le substrat support, on procède généralement à un dépôt d'une couche d'oxyde (par exemple un oxyde de silicium SiO₂) sur chacun des deux substrats, et on colle lesdits substrats par l'intermédiaire desdites couches d'oxyde.

Pour renforcer un tel collage oxyde-oxyde, il est connu d'effectuer, avant le collage, une activation par plasma des surfaces à coller, et, après le collage, un recuit de consolidation.

Ledit recuit de consolidation est typiquement réalisé à une température comprise entre 100°C et 300°C.

Or, le matériau piézoélectrique et le matériau du substrat support présentant des coefficients de dilatation thermique très différents, la mise en oeuvre d'un tel recuit engendre une déformation importante de l'assemblage.

Pour pallier ce type de problème, il est connu de recourir à un pseudo-substrat donneur, c'est-à-dire une hétérostructure dans laquelle le substrat piézoélectrique épais est collé sur un substrat de manipulation (« handle substrate » en anglais). Ainsi, après collage dudit pseudo-substrat donneur et du substrat support, le substrat piézoélectrique épais est maintenu entre le substrat de manipulation et le substrat support. Le choix des matériaux et des épaisseurs du substrat de manipulation et du substrat support permet d'assurer une certaine symétrie des coefficients de dilatation thermique, et ainsi de minimiser la déformation de l'assemblage lors l'application de traitements thermiques.

Le pseudo-substrat donneur pourrait ainsi être réalisé par assemblage du substrat piézoélectrique épais et d'un substrat de silicium, chacun recouvert d'une couche d'oxyde.

Cependant, une telle hétérostructure présente plusieurs inconvénients.

D'une part, le dépôt d'une couche d'oxyde sur le substrat piézoélectrique épais provoque une courbure (« bow » selon la terminologie-anglo-saxonne) importante dudit substrat piézoélectrique, peu compatible avec les étapes ultérieures du procédé, qui sont adaptées à des substrats plans.

Par ailleurs, la formation des couches d'oxyde nécessaires au collage est longue et coûteuse.

Enfin, comme mentionné plus haut, l'hétérostructure ne peut être soumise au recuit de consolidation en raison des différences de coefficients de dilatation thermique entre le substrat piézoélectrique épais et le substrat de manipulation. Or, en l'absence du recuit de consolidation, l'énergie de collage des couches d'oxyde des deux substrats reste très faible, de sorte que la tenue mécanique du pseudo-substrat donneur est insuffisante. Par conséquent, une rupture au niveau de l'interface de collage peut se produire lors de l'étape d'amincissement du substrat piézoélectrique épais.

Des procédés de transfert d'une couche mince à partir d'un substrat donneur vers un substrat receveur sont par exemple décrits dans WO 2017/052646, EP 0924769 et US 2003/0082889. Dans ces documents, il n'y a aucune divulgation d'une étape de photopolymérisation en combinaison avec une étape de fracture d'une couche piézoélectrique le long d'une zone de fragilisation à l'intérieur de la couche piézoélectrique.

### BREVE DESCRIPTION DE L'INVENTION

Un but de l'invention est de remédier aux inconvénients précités et notamment de concevoir un substrat donneur pour le transfert d'une couche piézoélectrique mince d'un substrat épais sur un substrat support, qui soit moins coûteux à réaliser, qui présente une meilleure tenue mécanique et/ou qui présente une courbure plus faible que les substrats existants.

A cet effet, l'invention propose un procédé selon la définition de la revendication 1.

La mise en oeuvre d'une couche adhésive photo-polymérisable pour assembler l'hétérostructure constituant le substrat donneur permet de conférer audit substrat une bonne tenue mécanique tout en s'affranchissant des étapes de procédé mises en oeuvre à haute température susceptibles d'engendrer une courbure importante du substrat. Par ailleurs, la formation d'une telle couche adhésive est très simple à mettre en oeuvre et est peu coûteuse.

D'autres aspects sont définis par les revendications dépendantes.

### BREVE DESCRIPTION DES DESSINS

D'autres caractéristiques et avantages de l'invention ressortiront de la description détaillée qui va suivre, en référence aux dessins annexés sur lesquels :
- la figure 1 illustre schématiquement l'étape de dépôt de la couche adhésive photo-polymérisable sur le substrat de manipulation ;
- la figure 2 illustre schématiquement l'étape de fourniture du substrat piézoélectrique épais ;
- la figure 3 illustre schématiquement une hétérostructure obtenue par collage du substrat piézoélectrique sur le substrat de manipulation par l'intermédiaire de la couche adhésive ;
- la figure 4 illustre schématiquement l'étape de polymérisation de la couche adhésive dans l'hétérostructure de sorte à former le pseudo-substrat donneur, dit simplement substrat donneur, selon l'invention ;
- la figure 5 illustre schématiquement l'étape d'implantation d'espèces atomiques dans le substrat donneur de la figure 4 de manière à y former une zone de fragilisation ;
- la figure 6 illustre schématiquement un substrat support sur lequel a été déposée une couche diélectrique ;
- la figure 7 illustre schématiquement l'étape de collage du substrat donneur fragilisé sur le substrat support ;
- la figure 8 illustre le substrat obtenu après fracture et séparation du substrat donneur le long de la zone de fragilisation ;
- la figure 9 est une illustration schématique d'un filtre à onde acoustique de volume selon un mode de réalisation de l'invention.

Pour des raisons de lisibilité des figures, les éléments illustrés ne sont pas nécessairement représentés à l'échelle. Par ailleurs, les éléments désignés par les mêmes signes de référence sur différentes figures sont identiques ou remplissent la même fonction.

### DESCRIPTION DETAILLEE DE MODES DE REALISATION DE L'INVENTION

Un premier objet de l'invention concerne un procédé de fabrication d'un substrat donneur pour le transfert d'une couche piézoélectrique sur un substrat support.

Le substrat donneur est fabriqué par collage d'un substrat piézoélectrique sur un substrat de manipulation.

Le substrat de manipulation est fabriqué dans un matériau dont le coefficient de dilatation thermique est proche de celui du matériau du substrat support sur lequel la couche piézoélectrique est destinée à être transférée. Par « proche », on entend une différence de coefficient de dilatation thermique entre le matériau du substrat de manipulation et le matériau du substrat support inférieure ou égale à 5%, et de préférence égale ou voisine de 0%. Des matériaux adaptés sont par exemple le silicium, le saphir, le nitrure d'aluminium (AIN) polycristallin, ou encore l'arséniure de gallium (GaAs). Dans la présente invention, on s'intéresse au coefficient de dilatation thermique dans un plan parallèle à la surface principale des substrats.

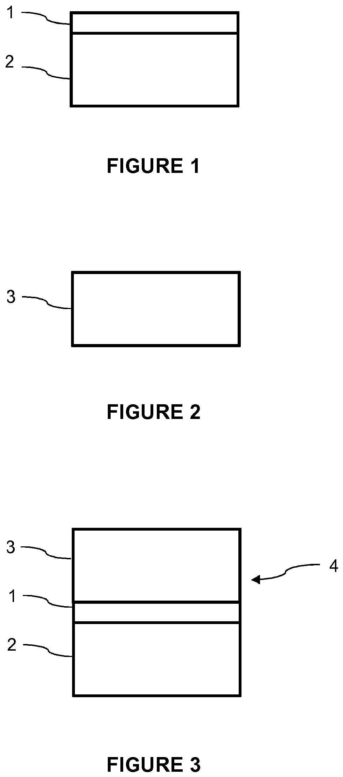

Selon une première étape représentée sur la figure 1, une couche adhésive photo-polymérisable 1 est déposée sur une face exposée du substrat de manipulation 2 ou du substrat piézoélectrique 3. Sur la figure 1, le dépôt est effectué sur le substrat de manipulation 2.

Le dépôt de la couche adhésive photo-polymérisable 1 est avantageusement effectué par enduction centrifuge, ou « spin coating » en terminologie anglosaxonne. Cette technique consiste à faire tourner le substrat sur lequel est prévu le dépôt de la couche photo-polymérisable sur lui-même à une vitesse sensiblement constante et relativement élevée, afin d'étaler ladite couche photo-polymérisable de façon uniforme sur l'ensemble de la surface du substrat par force centrifuge. A cet effet, le substrat est typiquement posé et maintenu par tirage du vide sur un plateau tournant.

L'homme du métier est en mesure de déterminer les conditions opératoires, telles que le volume d'adhésif déposé sur la surface du substrat, la vitesse de rotation du substrat, et la durée minimale du dépôt en fonction de l'épaisseur souhaitée pour la couche adhésive.

L'épaisseur de la couche adhésive photo-polymérisable est typiquement comprise entre 2 et 8 µm.

Selon un exemple non limitatif, la couche adhésive photo-polymérisable commercialisée sous la référence « NOA 61 » par la société NORLAND PRODUCTS peut être utilisée dans la présente invention.

Le substrat piézoélectrique, tel que représenté sur la figure 2, est ensuite collé sur le substrat de manipulation par l'intermédiaire de la couche adhésive 1, afin de former une hétérostructure 4, dont un mode de réalisation est représenté sur la figure 3.

L'hétérostructure 4 est ainsi formée de la superposition du substrat de manipulation 2, de la couche adhésive 1, et du substrat piézoélectrique 3, la couche adhésive se trouvant à l'interface entre le substrat de manipulation et le substrat piézoélectrique.

Le collage est de préférence réalisé à température ambiante, soit environ 20°C. Il est cependant possible de réaliser le collage à chaud à une température comprise entre 20°C et 50°C, et de manière davantage préférée entre 20°C et 30°C.

De plus, l'étape de collage est avantageusement effectuée sous vide, ce qui permet de désorber l'eau des surfaces formant l'interface de collage, c'est-à-dire la surface de la couche adhésive et la surface du substrat de manipulation ou du substrat piézoélectrique.

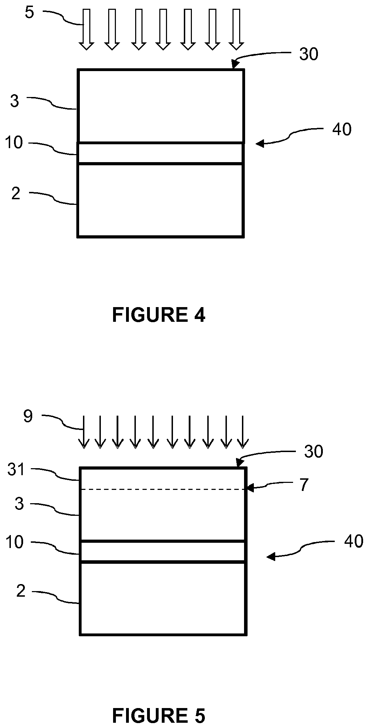

On soumet ensuite l'hétérostructure 4 à une irradiation par un flux lumineux 5, afin de polymériser la couche adhésive 1. L'irradiation de l'hétérostructure et représentée sur la figure 4.

La source lumineuse est de préférence un laser.

Le rayonnement lumineux, ou flux lumineux, est de préférence un rayonnement ultra-violet (UV). En fonction de la composition de la couche adhésive, on choisira de préférence un rayonnement UV présentant une longueur d'onde comprise entre 320 nm (nanomètres) et 365 nm.

L'irradiation est effectuée en exposant la face libre 30 du substrat piézoélectrique 3 au rayonnement lumineux incident. Ainsi, le rayonnement lumineux 5 pénètre dans l'hétérostructure 4 depuis la face libre 30 du substrat piézoélectrique, traverse le substrat piézoélectrique 3, jusqu'à atteindre la couche adhésive 1, provoquant ainsi la polymérisation de ladite couche adhésive.

La polymérisation de la couche adhésive 1 permet de former une couche polymère 10 qui assure la cohésion mécanique de l'hétérostructure, en maintenant collés ensemble le substrat de manipulation 2 et le substrat piézoélectrique 3 qui forment le substrat donneur.

L'irradiation de l'hétérostructure donne lieu à un processus thermique selon lequel la couche piézoélectrique, traversée par le rayonnement, peut absorber en partie l'énergie du rayonnement et s'échauffer. Un échauffement trop important serait susceptible de déstabiliser la structure de la couche piézoélectrique, ce qui pourrait aboutir à une dégradation des propriétés physiques et chimiques de la couche piézoélectrique. En outre, un échauffement trop important occasionnerait une déformation de la couche piézoélectrique et du substrat de manipulation en raison de leur différence de coefficient de dilatation thermique, aboutissant à une déformation globale, dite « bow » en terminologie anglo-saxonne, de l'hétérostructure et donc du substrat donneur résultant.

Afin d'éviter un échauffement trop important de la couche piézoélectrique, l'irradiation est avantageusement effectuée de manière impulsionnelle, c'est-à-dire en exposant l'hétérostructure à une pluralité d'impulsions de rayons lumineux. Chaque impulsion est réalisée pendant un temps d'irradiation déterminé, qui peut être égal ou différent d'une impulsion à l'autre. Les impulsions sont espacées dans le temps par un temps de repos déterminé pendant lequel l'hétérostructure n'est pas exposée aux rayons lumineux.

L'homme du métier est en mesure de déterminer le temps d'irradiation de chaque impulsion, le temps de repos entre chaque impulsion, ainsi que le nombre d'impulsions à réaliser pour polymériser complètement la couche adhésive.

Ainsi, par exemple, on pourra mettre en oeuvre une dizaine d'impulsions durant 10 secondes chacune, séparées par des temps de repos durant également 10 secondes chacun.

Après irradiation, on obtient un substrat donneur 40 constitué de l'hétérostructure 4 avec une couche adhésive polymérisée 10.

La couche adhésive polymérisée permet de coller le substrat piézoélectrique et le substrat de manipulation sans les exposer à un budget thermique qui serait susceptible de les déformer, ce qui permet de conférer au substrat donneur 40 une tenue mécanique suffisante pour le transfert ultérieur d'une couche piézoélectrique.

L'épaisseur de la couche adhésive polymérisée 10 est de préférence comprise entre 2 µm (micromètres) et 8 µm. Cette épaisseur dépend notamment du matériau constitutif de la couche adhésive photo-polymérisable déposée avant collage, de l'épaisseur de ladite couche adhésive photo-polymérisable, et des conditions expérimentales d'irradiation.

De manière optionnelle, le substrat donneur 40 est soumis à un traitement de surface visant à rendre la surface exposée de la couche piézoélectrique plane et à en réduire la rugosité.

Un deuxième objet de l'invention concerne un procédé de transfert d'une couche piézoélectrique sur un substrat support.

On fournit initialement un substrat donneur comprenant la couche piézoélectrique à transférer. Le substrat donneur est de préférence obtenu par le procédé de fabrication décrit précédemment selon le premier objet de l'invention.

On fournit également un substrat support 6 apte à recevoir la couche piézoélectrique à transférer. Le substrat support est de préférence en silicium.

Selon une première étape représentée sur la figure 5, on forme une zone de fragilisation 7 dans le substrat piézoélectrique 3, de manière à délimiter la couche piézoélectrique à transférer 31. La profondeur de la zone de fragilisation 7 par rapport à la surface exposée du substrat piézoélectrique détermine l'épaisseur de la couche piézoélectrique à transférer.

Selon un mode de réalisation préféré, la zone de fragilisation est formée par implantation d'espèces atomiques dans le substrat piézoélectrique, l'implantation étant représentée sur la figure 5 par les flèches 9. Les espèces atomiques sont implantées à une profondeur déterminée du substrat piézoélectrique qui détermine l'épaisseur de la couche piézoélectrique à transférer.

Lorsque la zone de fragilisation est formée par implantation d'espèces atomiques, les espèces atomiques implantées sont de préférence des ions hydrogène et/ou des ions hélium.

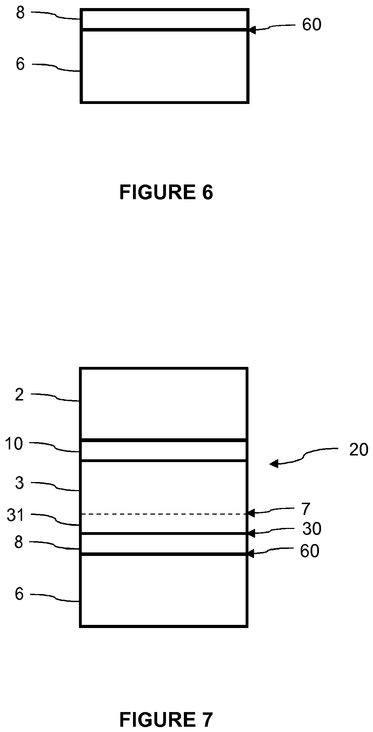

On forme ensuite une couche diélectrique 8 sur une face principale du substrat support 6 et/ou du substrat piézoélectrique. La figure 6 représente le substrat support 6 sur lequel a été déposée une couche diélectrique 8.

De préférence, la couche diélectrique est une couche de verre déposée par centrifugation sur le substrat piézoélectrique, dite « spin-on glass » (SOG) selon la terminologie anglo-saxonne. Cette technique est avantageuse en ce que le dépôt de la couche est effectuée à température ambiante, et suivie d'un recuit de densification à une température d'environ 250°C, et n'engendre donc pas de déformation du substrat sur lequel la couche diélectrique est formée.

De manière optionnelle, la surface 30 ou 60 à coller sur laquelle la couche diélectrique n'a pas été déposée, du substrat donneur 40 ou du substrat support 6, subit un traitement adapté pour permettre ultérieurement un collage moléculaire hydrophile de cette surface avec l'autre surface respective. De préférence, un tel traitement consiste à former sur le substrat support une couche d'oxyde, ou une couche de nitrure, ou une couche comprenant une combinaison de nitrure et d'oxyde, ou une superposition d'une couche d'oxyde et d'une couche de nitrure. Par exemple, dans le cas d'un substrat support en silicium, on pourra former une couche d'oxyde SiO₂, ou une couche de nitrure Si₃N₄, une couche comprenant une combinaison de nitrure et d'oxyde SiOxNy, ou une superposition d'une couche d'oxyde SiO₂ et d'une couche de nitrure Si₃N₄.

On formera de préférence une couche d'oxyde de silicium lorsque le substrat support est en silicium.

On procède par la suite au collage du substrat donneur 40 sur le substrat support 6, tel qu'illustré sur la figure 7.

Le collage est effectué de manière à ce que la couche diélectrique 8 se trouve à l'interface de collage. La structure multicouche 20 formée comprend alors successivement le substrat support 6, la couche diélectrique 8, la couche piézoélectrique à transférer 31 du substrat piézoélectrique 3, la couche polymère 10, et le substrat de manipulation 2.

Après collage, la structure multicouche 20 est soumise à un recuit thermique et la substrat donneur 40 est détaché du substrat support 6 le long de la zone de fragilisation 7, permettant ainsi le transfert de la couche piézoélectrique 31 sur le substrat support 6.

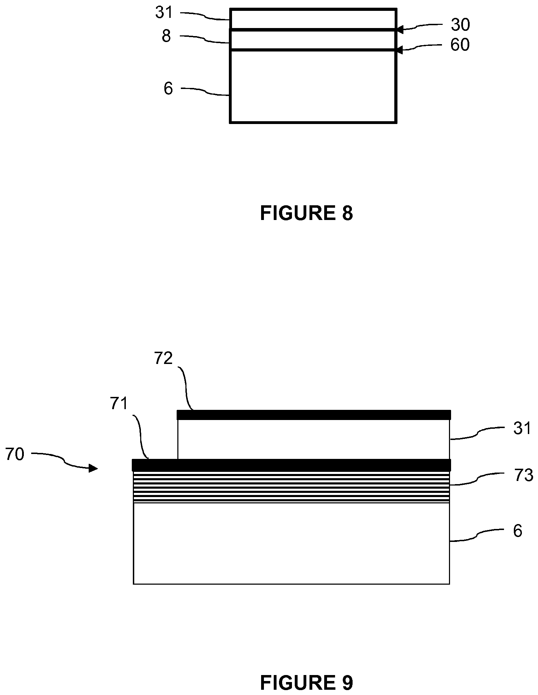

La figure 8 illustre la structure finale obtenue après fracture et séparation du pseudo-substrat donneur le long de la zone de fragilisation, comprenant la couche piézoélectrique transférée 31 agencée sur le substrat support 6, avec la couche diélectrique 8 située à l'interface de la couche piézoélectrique transférée 31 et du substrat support 6.

L'étape de fracture et de séparation du substrat donneur est effectuée à une température telle que la couche adhésive polymérisée n'est pas dégradée. Une température inférieure ou égale à 300°C permet d'éviter une telle dégradation de la couche adhésive polymérisée. Une température de l'ordre de 160°C est suffisante pour fracturer le substrat piézoélectrique le long de la zone de fragilisation.

Le substrat piézoélectrique étant maintenu entre deux substrats (à savoir, le substrat de manipulation et le substrat support) dont les coefficients de dilatation thermique sont proches, il n'est pas soumis à une déformation différentielle lors de la mise en oeuvre du recuit.

Un troisième objet de l'invention concerne une application non limitative du procédé de transfert selon le deuxième objet de l'invention. Il est proposé un procédé de fabrication d'un dispositif à ondes acoustiques de volume comprenant le dépôt d'électrodes sur deux faces opposées d'une couche piézoélectrique fabriquée selon le procédé de transfert selon le deuxième objet de l'invention.

La figure 9 est une vue de principe d'un résonateur à ondes acoustiques de volume.

Le résonateur 70 comprend une couche piézoélectrique mince 31 (c'est-à-dire d'épaisseur généralement inférieure à 1 µm, de préférence inférieure à 0,2 µm) et deux électrodes 71, 72 agencées de part et d'autre de ladite couche piézoélectrique 31. La couche piézoélectrique 31 repose sur un substrat support 6. Pour isoler le résonateur du substrat et éviter ainsi la propagation des ondes dans le substrat, un miroir de Bragg 73 est interposé entre l'électrode 71 et le substrat 6. De manière alternative (non illustrée), cette isolation pourrait être réalisée en ménageant une cavité entre le substrat et la couche piézoélectrique. Ces différentes dispositions sont connues de l'homme du métier et ne seront donc pas décrites en détail dans le présent texte.

Dans certains cas, le substrat support peut ne pas être optimal pour l'application finale. Il peut alors être avantageux de transférer la couche 31 sur un substrat final (non représenté) dont les propriétés sont choisies en fonction de l'application visée, en la collant sur ledit substrat final et en retirant le substrat support par toute technique adaptée.

Pour fabriquer un dispositif à ondes acoustiques de volume, selon un mode de réalisation, une adaptation du procédé décrit précédemment doit être effectuée. D'une part, on dépose, avant l'étape de collage illustrée sur la figure 7, une première électrode sur la surface libre de la couche 31 à transférer du substrat donneur, cette première électrode (référencée 71 sur la figure 9) se trouvant enterrée dans l'empilement final. Après l'étape de transfert illustrée sur la figure 8, on dépose une seconde électrode (référencée 72 sur la figure 9) sur la surface libre de la couche 31, opposée à la première électrode. Une autre option est de transférer la couche 31 sur un substrat final comme mentionné plus haut et de former les électrodes avant et après ledit transfert. D'autre part, pour éviter la propagation des ondes acoustiques dans le substrat support 6, on peut intégrer à celui-ci un moyen d'isolation pouvant être, par exemple, un miroir de Bragg (comme illustré sur la figure 9) ou une cavité préalablement gravée dans le substrat support ou dans le substrat final le cas échéant.

Enfin, il va de soi que l'application que l'on vient de donner n'est qu'une illustration particulière en aucun cas limitative quant aux domaines d'application de l'invention.

## Revendications

1. Procédé de transfert d'une couche piézoélectrique (3) sur un substrat support (6), comprenant :
- la fourniture d'un substrat donneur (40) constitué d'une hétérostructure (4) comprenant un substrat piézoélectrique (3) collé sur un substrat de manipulation (2), et une couche adhésive polymérisée par photopolymérisation (10) à l'interface entre le substrat piézoélectrique (3) et le substrat de manipulation (2),
- la formation d'une zone de fragilisation (7) dans le substrat piézoélectrique (3), de manière à délimiter la couche piézoélectrique à transférer (31),
- la fourniture du substrat support (6),
- la formation d'une couche diélectrique (8) sur une face principale du substrat support (6) et/ou du substrat piézoélectrique (3),
- le collage du substrat donneur (40) sur le substrat support (6), ladite couche diélectrique (8) étant à l'interface de collage,
- la fracture et la séparation du substrat donneur (40) le long de la zone de fragilisation (7), à une température inférieure ou égale à 300°C.

2. Procédé selon la revendication 1, dans lequel la couche diélectrique (8) est une couche de verre déposée par centrifugation sur le substrat piézoélectrique.

3. Procédé selon la revendication 1 ou la revendication 2, comprenant, avant le collage, la formation d'une couche d'oxyde, ou une couche de nitrure, ou une couche comprenant une combinaison de nitrure et d'oxyde, ou une superposition d'au moins une couche d'oxyde et d'une couche de nitrure sur le substrat support (6).

4. Procédé selon l'une quelconque des revendications 1 à 3, dans lequel la formation de la zone de fragilisation (7) est effectuée par implantation d'espèces atomiques (9) dans le substrat piézoélectrique.

5. Procédé selon l'une quelconque des revendications 1 à 4, dans lequel le substrat de manipulation (2) est un substrat en silicium, en saphir, en nitrure d'aluminium (AIN) polycristallin, ou en arséniure de gallium (GaAs).

6. Procédé selon l'une quelconque des revendications 1 à 5, dans lequel l'épaisseur de la couche adhésive polymérisée (10) est comprise entre 2 µm et 8 µm.

7. Procédé selon l'une des revendications 1 à 6, comprenant la fabrication du substrat donneur (40) par les étapes suivantes :
- la fourniture du substrat piézoélectrique (3),
- la fourniture du substrat de manipulation (2),
- le dépôt d'une couche adhésive photo-polymérisable sur une face principale du substrat de manipulation (2) ou du substrat piézoélectrique (3),
- le collage du substrat piézoélectrique (3) sur le substrat de manipulation (2) par l'intermédiaire de la couche adhésive, pour former l'hétérostructure (4),
- l'irradiation de ladite hétérostructure (4) par un flux lumineux pour polymériser la couche adhésive, de sorte à former ledit substrat donneur.

8. Procédé de fabrication d'un dispositif à ondes acoustiques de volume (70), comprenant le dépôt d'électrodes (71, 72) sur deux faces opposées d'une couche piézoélectrique (31), **caractérisé en ce qu'**il comprend la fabrication de ladite couche piézoélectrique (31) par un procédé selon l'une des revendications 1 à 7.

## Patentansprüche

1. Verfahren zur Übertragung einer piezoelektrischen Schicht (3) auf ein Trägersubstrat (6), umfassend:
- Bereitstellung eines Donorsubstrats (40), bestehend aus einer Heterostruktur (4), die ein piezoelektrisches Substrat (3) umfasst, das auf ein Handhabungssubstrat (2) geklebt ist, und eine durch Photopolymerisation polymerisierte Klebeschicht (10) an der Schnittstelle zwischen dem piezoelektrischen Substrat (3) und dem Handhabungssubstrat (2),
- Bildung einer Versprödungszone (7) im piezoelektrischen Substrat (3), um die zu übertragende piezoelektrische Schicht (31) abzugrenzen,
- Bereitstellung des Trägersubstrats (6),
- Bildung einer dielektrischen Schicht (8) auf einer Hauptseite des Trägersubstrats (6) und/oder des piezoelektrischen Substrats (3),
- Klebung des Donorsubstrats (40) auf das Trägersubstrat (6), wobei die dielektrische Schicht (8) an der Klebeschnittstelle liegt,
- Bruch und Trennung des Donorsubstrats (40) entlang der Versprödungszone (7) bei einer Temperatur von 300 °C oder darunter.

2. Verfahren nach Anspruch 1, wobei die dielektrische Schicht (8) eine durch Zentrifugation auf das piezoelektrische Substrat aufgebrachte Glasschicht ist.

3. Verfahren nach Anspruch 1 oder Anspruch 2, das vor dem Kleben die Bildung einer Oxidschicht oder einer Nitridschicht oder einer Schicht umfasst, die eine Kombination aus Nitrid und Oxid oder eine Überlagerung von wenigstens einer Oxidschicht und einer Nitridschicht auf dem Trägersubstrat (6) umfasst.

4. Verfahren nach einem der Ansprüche 1 bis 3, wobei die Bildung der Versprödungszone (7) durch Implantation von Atomspezies (9) in das piezoelektrische Substrat erfolgt.

5. Verfahren nach einem der Ansprüche 1 bis 4, wobei das Handhabungssubstrat (2) ein Substrat aus Silizium, Saphir, polykristallinem Aluminiumnitrid (AIN) oder Galliumarsenid (GaAs) ist.

6. Verfahren nach einem der Ansprüche 1 bis 5, wobei die Dicke der polymerisierten Klebeschicht (10) zwischen 2 µm und 8 µm liegt.

7. Verfahren nach einem der Ansprüche 1 bis 6, umfassend die Herstellung des Donorsubstrats (40) durch die folgenden Schritte:
- Bereitstellung des piezoelektrischen Substrats (3),
- Bereitstellung des Handhabungssubstrats (2),
- Aufbringen einer photopolymerisierbaren Klebeschicht auf eine Hauptseite des Handhabungssubstrats (2) oder des piezoelektrischen Substrats (3),
- Aufkleben des piezoelektrischen Substrats (3) auf das Handhabungssubstrat (2) über die Klebeschicht, um die Heterostruktur (4) zu bilden,
- Bestrahlung der Heterostruktur (4) durch einen Lichtstrom zum Polymerisieren der Klebeschicht, sodass das Donorsubstrat gebildet wird.

8. Verfahren zur Herstellung einer Volumenschallwellenvorrichtung (70), umfassend das Aufbringen von Elektroden (71, 72) auf zwei gegenüberliegenden Seiten einer piezoelektrischen Schicht (31), **dadurch gekennzeichnet, dass** es die Herstellung der piezoelektrischen Schicht (31) durch ein Verfahren nach einem der Ansprüche 1 bis 7 umfasst.

## Claims

1. Process for transferring a piezoelectric layer (3) onto a support substrate (6), comprising :
- the provision of a donor substrate (40) consisting of a heterostructure (4) comprising a piezoelectric substrate (3) bonded to a handling substrate (2), and a photopolymerized adhesive layer (10) at the interface between the piezoelectric substrate (3) and the handling substrate (2),
- forming an embrittlement zone (7) in the piezoelectric substrate (3), so as to delimit the piezoelectric layer to be transferred (31),
- supply of the support substrate (6),
- forming a dielectric layer (8) on a major face of the support substrate (6) and/or the piezoelectric substrate (3),
- bonding the donor substrate (40) to the support substrate (6), with said dielectric layer (8) at the bonding interface,
- fracture and separation of the donor substrate (40) along the embrittlement zone (7), at a temperature of 300°C or less.

2. Process according to claim 1, wherein the dielectric layer (8) is a glass layer spin-coated onto the piezoelectric substrate.

3. A method according to claim 1 or claim 2, comprising, prior to bonding, forming an oxide layer, or a nitride layer, or a layer comprising a combination of nitride and oxide, or a superposition of at least one oxide layer and one nitride layer on the support substrate (6).

4. Process according to any one of claims 1 to 3, wherein the formation of the embrittlement zone (7) is carried out by implanting atomic species (9) into the piezoelectric substrate.

5. Process according to any one of claims 1 to 4, wherein the handling substrate (2) is a silicon, sapphire, polycrystalline aluminum nitride (AIN) or gallium arsenide (GaAs) substrate.

6. Process according to any one of claims 1 to 5, wherein the thickness of the polymerized adhesive layer (10) is between 2 µm and 8 µm.

7. A method according to any of claims 1 to 6, comprising manufacturing the donor substrate (40) by the following steps:
- supply of the piezoelectric substrate (3),
- supply of the handling substrate (2),
- depositing a photopolymerizable adhesive layer on one main face of the handling substrate (2) or piezoelectric substrate (3),
- bonding the piezoelectric substrate (3) to the handling substrate (2) via the adhesive layer, to form the heterostructure (4),
- irradiating said heterostructure (4) with a luminous flux to polymerize the adhesive layer, thereby forming said donor substrate.

8. Method of manufacturing a bulk acoustic wave device (70), comprising the deposition of electrodes (71, 72) on two opposite faces of a piezoelectric layer (31), **characterized in that** it comprises the manufacture of said piezoelectric layer (31) by a method according to one of claims 1 to 7.
